Europäisches Patentamt

European Patent Office

Office européen des brevets

(11) Veröffentlichungsnummer: **0 299 136**

**A2**

## (12) EUROPÄISCHE PATENTANMELDUNG

(21) Anmeldenummer: 88102681.9

(22) Anmeldetag: 24.02.88

(51) Int. Cl.4: **H05K 3/40 , H05K 3/46**

(30) Priorität: 14.07.87 DE 3723236

(43) Veröffentlichungstag der Anmeldung:
**18.01.89 Patentblatt 89/03**

(84) Benannte Vertragsstaaten:
**AT BE CH DE ES FR GB GR IT LI NL SE**

(71) Anmelder: **Thaler, Hartmuth F., Ing. grad.
Hohe Strasse 15
D-7110 Öhringen(DE)**

(72) Erfinder: **Thaler, Hartmuth F., Ing. grad.
Hohe Strasse 15
D-7110 Öhringen(DE)**

(74) Vertreter: **Charrier, Rolf, Dipl.-Ing.
Postfach 260 Rehlingenstrasse 8
D-8900 Augsburg 31(DE)**

(54) **Verfahren zur Herstellung einer Schaltungsplatte.**

(57) Zum Herstellen einer Schaltungsplatte, bei der Leiterbahnen (2, 5) beidseits einer Isolierschicht (1) miteinander zu verbinden sind, wird auf eine die eine Leiterbahn (2) bildende Metallschicht die Isolierschicht (1) aufgelegt und in eine Ausnehmung (8) der Isolierschicht (1) eine Kugel (11) eingebracht. Die Kugel (11) weist einen Durchmesser auf, der größer ist als die Dicke (d) der Isolierschicht (1). Sodann wird auf die Isolierschicht (1) eine die andere Leiterbahn (5) bildende Metallschicht aufgelegt und anschließend werden die Schichten unter Wärmezufuhr miteinander verpreßt, wobei die Metallschichten auf die Isolierschicht (1) aufkaschiert werden und die Kugel (11) Diffusionsschweißverbindungen mit den Metallschichten bildet. Anschließend werden die Metallschichten zur Bildung der Leiterbahnen (2, 5) geätzt.

Fig. 2

Die Erfindung betrifft ein Verfahren zur Herstellung einer Schaltungsplatte nach dem Oberbegriff des Anspruches 1.

Ein Verfahren zur Herstellung von Schaltungsplatten ist der DE-PS 19 23 199 entnehmbar. Bei diesem bekannten Verfahren werden die beiden aus Metallfolie bestehenden Metallschichten, die durch eine Isolierschicht voneinander getrennt sind, an den Stellen der Ausnehmungen der Isolierschicht miteinander verlötet. Beim Verlöten werden die beiden Metallfolienschichten an den Ausnehmungen unter Erwärmung zusammengepreßt, bis die zusammengepreßten Metallschichten miteinander verkleben. Zu diesem Zweck weisen die Metallfolienschichten im Bereich der Ausnehmung aus Lot bestehende Kontaktflecken auf. Weiterhin ist es möglich, in die Ausnehmung zwischen den beiden Metallfolienschichten Kügelchen oder Scheiben aus niedrig schmelzendem Lot einzubringen.

Bei diesem Verfahren ist es erforderlich, die beiden Metallfolienschichten beim Zusammenpressen zu deformieren, bis sie einander berühren, wobei das Lot schmilzt. Es hat sich gezeigt, daß diese Deformation der beiden Metallfolienschichten die Ursache von Ausschußplatten darstellt, da es unvermeidbar ist, daß bei noch nicht erstarrtem Lot die Metallfolien infolge ihrer Elastizität in ihre Ursprungslage zurückfedern und somit die Lotbrücke zwischen den beiden Metallfolienschichten unterbrochen wird. Daneben ist es unvermeidbar, daß kalte Lötstellen entstehen. Ein weiterer Nachteil ist darin zu sehen, daß die Ausnehmungen relativ groß gewählt werden müssen, damit die Deformation der Metallfolienschichten nicht auf einem engbegrenzten Bereich stattfindet.

Nach dem DE-GM 19 20 061, von der im Oberbegriff des Anspruches 1 ausgegangen wird, erfolgt die Verbindung der Metallfolienschichten durch Schweißen. Zusätzlich wird dort in die Ausnehmung der Isolierschicht ein zylindrischer Metallkörper eingesetzt, der dann beidseits mit den Metallschichten verschweißt wird. Die Dicke des Metallkörpers ist jedoch geringer als diejenige der Isolierschicht, so daß auch hier eine Deformation der Metallfolien in Richtung des Metallkörpers stattfindet. Das Verschweißen kann nur durch Punktschweißelektroden durchgeführt werden, die zur Deformation der Metallfolien einen Druck auf diese ausüben. Das Verschweißen ist relativ zeitaufwendig und erfordert eine große Sorgfalt.

Es besteht die Aufgabe, das Verfahren so auszubilden, daß eine sichere elektrische Verbindung zwischen den Metallfolienschichten erzeugt wird.

Gelöst wird diese Aufgabe mit den kennzeichnenden Merkmalen des Anspruches 1. Vorteilhafte Ausgestaltungen sind den Unteransprüchen entnehmbar.

Ausführungsbeispiele werden nachfolgend anhand der Zeichnungen näher erläutert. Es zeigen:

Fig. 1 eine perspektivische Ansicht einer schematisch dargestellten Schaltungsplatte;

Fig. 2 einen Schnitt durch die Schaltungsplatte längs der Linie II-II der Fig. 1 zur Erläuterung einer ersten Ausführungsform des Verfahrens;

Fig. 3 einen Schnitt durch eine mehrlagige Schaltungsplatte in Explosivdarstellung;

Fig. 4 einen Schnitt durch eine Schaltungsplatte zur Erläuterung einer zweiten Ausführungsform des Verfahrens;

Fig. 5 einen Schnitt durch die Lagenanordnung zur Erläuterung eines Schritts einer weiteren Ausführungsform des Verfahrens,

Fig. 6 einen der Fig. 5 entsprechenden Schnitt zur Erläuterung eines weiteren Schritts;

Fig. 7 einen Schnitt zur Erläuterung der Herstellung einer vier Leiterschichten aufweisenden Platte und

Fig. 8 einen Schnitt durch eine weitere Platte.

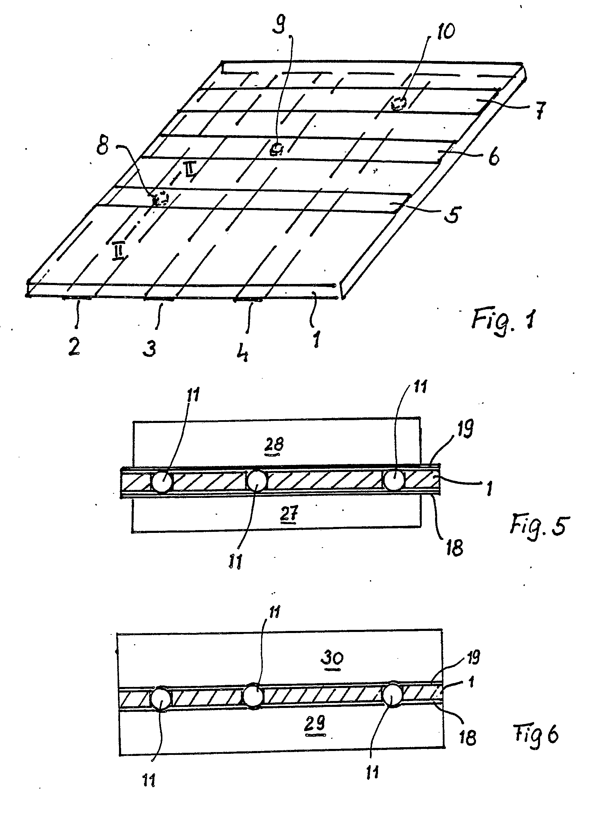

Gemäß Fig. 1 weist die Schaltungsplatte eine Isolierschicht 1 auf, an deren Unterseite drei Metallfolienstreifen 2, 3, 4 aufkaschiert sind. Diese drei Streifen 2, 3, 4 bilden die eine aus Metallfolie bestehende Metallschicht. Auf der Oberseite der Isolierplatte 1 sind drei weitere aus Metallfolie bestehende Leiterbahnen 5, 6, 7 aufkaschiert, welche die andere aus Metallfolie bestehende Metallschicht bilden.

Die Isolierschicht 1 weist eine erste Ausnehmung 8 auf, in die ein erster aus einem hochschmelzenden Metall bestehender Körper eingesetzt ist, über welchen die Leiterbahnen 2 und 5 miteinander verbunden werden. In zwei weitere Ausnehmungen 9, 10 der Isolierschicht 1 sind ebenfalls jeweils ein Metallkörper eingesetzt, über die dann die Leiterbahnen 3 und 6 bzw. 4 und 7 miteinander verbunden werden.

Nach einem ersten Ausführungsbeispiel des Verfahrens wird in die Isolierschicht 1 eine kreisförmige Ausnehmung 8 eingestanzt, deren Durchmesser gleich der Dicke d der Isolierschicht 1 ist. Nach dem Erzeugen der Ausnehmung 8 und eventuell weiterer Ausnehmungen 9, 10 der gleichen Form und Abmessung wird die erste aus Metallfolie bestehende Metallschicht, im gezeigten Beispiel die Leiterbahn 2, auf die eine Seite der Isolierschicht 1 aufkaschiert, wobei die Leiterbahn 2 über die Ausnehmung 8 geführt ist. In diese Ausnehmung 8 wird nunmehr eine Kugel 11 eingedrückt, deren Durchmesser geringfügig größer ist als die Dicke d der Isolierschicht 1.

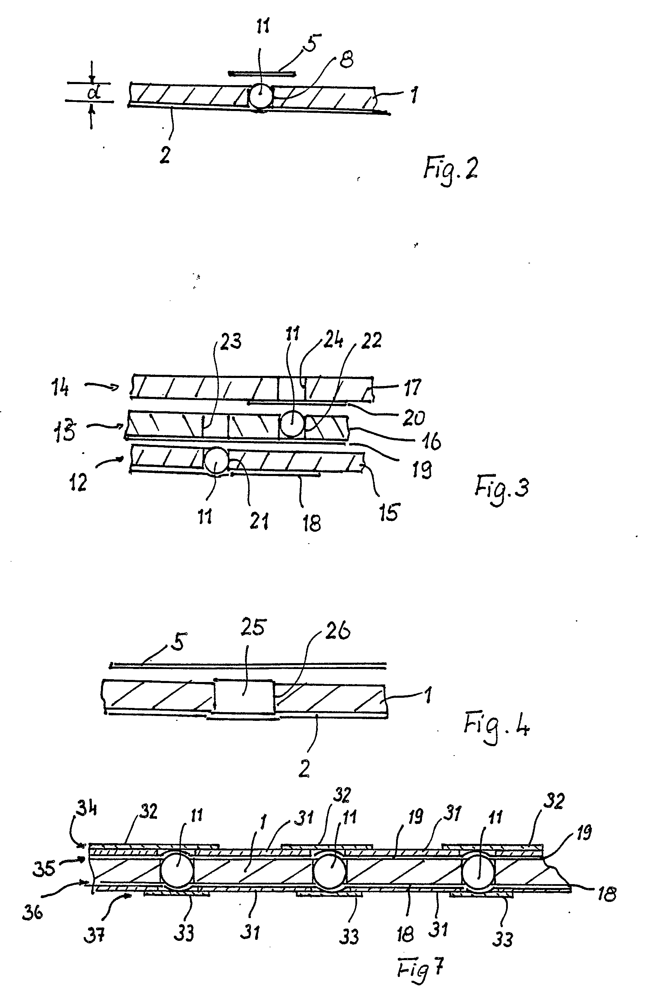

Diese Kugel 11 steht dann oben und unten geringfügig über die Oberflächen der Isolierschicht 1 über, so daß durch den unten überstehenden Bereich der Kugel 11 dort die Leiterbahn 2 deformiert wird. Sodann wird auf die andere Seite der Isolierschicht 1 die andere aus Metallfolie bestehende Schicht aufkaschiert, im gezeigten Beispiel die Leiterbahn 5, wobei diese Leiterbahn 5 über die Ausnehmung 8 und die Kugel 11 geführt ist. In Fig. 2 ist der Zustand vor dem Aufkaschieren der Leiterbahn 5 gezeigt.

Beim Aufkaschieren der Leiterbahn 5 wird diese durch den oben überstehenden Bereich der Kugel 11 deformiert. Beide Leiterbahnen 2, 5 liegen an den deformierten Bereichen eng an die Kugel 11 an, da deren Durchmesser geringfügig größer ist als die Dicke der Isolierschicht 1. Die beiden Leiterbahnen 2, 5 werden nunmehr im Berührungsbereich mit der Kugel 11 mit dieser verschweißt. Dieses Verschweißen kann durch den Einsatz von Laserstrahlen erfolgen, welche im Kontaktbereich mit der Kugel 11 gegen die Leiterbahnen 2, 5 gerichtet sind. Beim Verschweißen findet ein Schmelzvorgang bei der Kugel 11 lediglich an den Berührungsbereichen mit den Leiterstreifen 2, 5 statt.

Beim Einsetzen der Kugel 11 in die Ausnehmung 8 liegt die Isolierplatte 1 mit der Leiterbahn 2 auf einer nachgiebigen Unterlage auf, damit die Leiterbahn 2 durch den unten überstehenden Bereich der Kugel 11 dort deformiert werden kann. Beim Aufkaschieren der Leiterbahn 5 wird eine ebenfalls nachgiebige Auflage verwendet, wobei die Schaltungsplatte zwischen Unterlage und Auflage gepreßt wird, so daß die Leiterbahn 5 im Bereich der Kugel 11 deformiert wird.

Anstelle des Verschweißens der Leiterbahnen 2, 5 mit der Kugel 11 durch einen Laserstrahl, ist es auch möglich, eine Diffusionsverschweißung durchzuführen. Hierzu wird nach dem Aufkaschieren der Leiterbahnen 2, 5 die Schaltungsplatte zwischen einer metallischen Auflage und einer metallischen Unterlage unter Wärmezufuhr verpreßt, so daß an den Kontaktstellen zwischen der Kugel 11 und den Leiterbahnen 2, 5 eine Diffusionsverschweißung auftritt. Auf diese Weise können in einem Arbeitsgang alle elektrischen Verbindungen zwischen den Leiterbahnen 2, 3, 4 auf der einen Seite der Isolierschicht 1 und den Leiterbahnen 5, 6, 7 auf der anderen Seite über Kugeln 11 hergestellt werden.

Die Fig. 3 verdeutlicht die Herstellung einer mehrschichtigen Schaltungsplatte, welche aus drei Einzelplatten 12, 13, 14 aufgebaut ist. Jede Einzelplatte weist eine Isolierschicht 15, 16, 17 und eine auf ihrer Unterseite aufkaschierte Metallfolienschicht 18, 19, 20 auf. Die Isolierschicht 15 wurde mit einer Ausnehmung 21 versehen, bevor die Metallfolienschicht 18 aufkaschiert wurde. In diese Ausnehmung 21 wird dann eine Metallkugel 11 eingesetzt, die mit der Metallfolienschicht 18 verschweißt wird. Die Isolierschicht 16 wurde mit zwei Ausnehmungen 22, 23 versehen, bevor die Metallfolienschicht 19 aufkaschiert wurde. Die Ausnehmung 23 befindet sich an der Stelle, wo sich die Ausnehmung 21 in der Isolierschicht 15 befindet. In die Ausnehmung 22 wird dann ebenfalls eine Kugel 11 eingebracht und mit der Metallfolienschicht 19 verschweißt. Die beiden Einzelplatten 12, 13 werden aufeinandergelegt und sodann die Metallfolienschicht 19 über die Ausnehmung 23 mit der Kugel 11 verschweißt. Sodann wird auf die Einzelplatte 13 die Einzelplatte 14 aufgelegt, deren Isolierschicht 17 an der Stelle der Ausnehmung 22 eine Ausnehmung 24 aufweist. Über diese Ausnehmung 24 wird dann die die Ausnehmung 24 abdeckende Metallfolien schicht 20 mit der Kugel 11 in der Ausnehmung 22 verschweißt. In entsprechender Weise wird mit den weiteren Schichten verfahren.

Gemäß dem Ausführungsbeispiel des Verfahrens nach Fig. 4 wird in die Isolierschicht 1 ein scharfkantiger flacher Metallkörper 25 eingepreßt, dessen Dicke geringfügig größer ist als die Dicke der Isolierschicht 1. Beim Einpressen dieses Metallkörpers 25 wird die Ausnehmung 26 erzeugt, in welcher der Metallkörper 25 festsitzt. Sodann wird auf der Unterseite der Isolierschicht 1 die Metallfolienschicht 2 und auf die Oberseite die Metallfolienschicht 5 aufkaschiert. Dies kann im gleichen Arbeitsgang erfolgen. Nach dem Aufkaschieren der Metallfolienschichten 2, 5 werden diese in einer der zuvor beschriebenen Weise mit dem Metallkörper 25 verschweißt. Aufkaschieren und Diffusionsverschweißen können im gleichen Arbeitsgang durchgeführt werden.

Für den Aufbau einer mehrschichtigen Schaltungsplatte nach Fig. 3 aus Einzelplatten entsprechend der Fig. 4 werden Einzelplatten verwendet, die jeweils aus einer Isolierschicht 1 und einer Metallfolienschicht 2 sowie den in die Isolierschicht 1 eingesetzten Metallkörper 25 bestehen, wobei dann die weiteren darauf angeordneten Einzelplatten zusätzliche Ausnehmungen entsprechend den Ausnehmungen 23, 24 nach Fig. 3 aufweisen.

Vorstehend wurde vom Aufkaschieren von Leiterbahnen 2 bis 7 gesprochen. Natürlich können diese Leiterbahnen auch erzeugt werden, indem auf jede Oberfläche der Isolierschicht 1 eine durchgehende Metallschicht aufkaschiert wird und danach die Leiterbahnen durch Abätzen der dazwischenliegenden Bereiche erzeugt werden. Dieses Abätzen kann vor oder nach dem Verschweißen der Metallkörper 11, 25 mit den Metallschichten erfolgen.

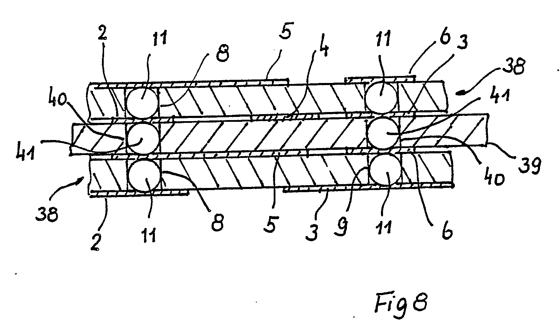

Ein bevorzugtes Verfahren wird nachfolgend anhand der Figuren 5 bis 7 beschrieben. Nach dem die Metallkugeln 11 in die Isolierplatte 1 eingesetzt wurden, wird die Isolierplatte 1 auf die Metallfolienschicht 18 und auf die Isolierplatte 1 die Metallfolienschicht 19 aufgelegt. Diese Lagen werden zwischen einer flachen metallischen Unterlage 27 und einer dazu parallelen metallischen Auflage 28 unter Druck und Wärmezufuhr verpreßt, wodurch an den Berührungsbereichen zwischen den Kugeln 11 und den Metallschichten 18, 19 eine Diffusionsverschweißung stattfindet.

Anschließend werden die Lagen zwischen eine flache nachgiebige Unterlage 29 und eine nachgiebige flache Auflage 30 gebracht und unter Druck verpreßt, womit die Metallschichten 18, 19 an den überstehenden Bereichen der Kugeln 11 deformiert und gleichzeitig die Schichten 18, 19 auf die Isolierschicht 1 aufkaschiert werden.

Die nachfolgend beschriebene weitere Vorgehensweise gilt für alle Ausführungsbeispiele und führt zu einer Schaltungsplatte mit vier Leiterebenen. Nach dem Herstellen der aus den Schichten 1, 18, 19 bestehenden Schaltungsplatte wird diese zur Erzeugung der Leiterbahnen geätzt. Sodann wird auf den beiden Oberflächen dieser Schaltungsplatte jeweils eine Isolierschicht 31 aufgebracht, welche an den deformierten Stellen der Leiterbahnen ausgespart ist, an denen elektrische Verbindungen mit weiteren noch aufzubringenden Leiterbahnen hergestellt werden sollen. Diese weiteren Leiterbahnen, z.B. die Leiterbahnen 32, 33 werden auf die Isolierschichten 31 aufkaschiert und an den von den Isolierschichten 31 freigelassenen Stellen mit den darunterliegenden Leiterbahnen verschweißt. Es entstehen somit auf jeder Seite der Isolierplatte 1 zwei Leiterbahnebenen 34, 35 bzw. 36, 37. Die Leiterbahnen 32, 33 können auch mittels Siebdruck aufgebracht werden.

Die Fig. 8 dient zur Erläuterung der Herstellung einer weiteren mehrschichtigen Schaltungsplatte. Diese besteht aus Einzelplatten 38 mit dazwischenliegenden Isolierplatten 39.

Die Einzelplatten 38 bestehen jeweils aus einer Isolierschicht 1 und beidseits darauf angeordneten Leiterbahnen 2 bis 6. Diese Einzelplatten werden wie vorbeschrieben hergestellt. Bevorzugt wird auf eine Metallschicht 18 die Isolierschicht 1 aufgelegt, in die Ausnehmungen 8, 9, 10 die Kugeln 11 eingelegt und auf die Isolierschicht 1 eine Metallschicht 19 aufgelegt. Die Ausnehmungen 8, 9, 10 sind geringfügig größer als der Durchmesser der Kugeln 11. In einem Arbeitsgang werden dann die Metallschichten 18, 19 mit der Isolierschicht 1 kaschiert und hierbei die Diffusionsschweißverbindungen zwischen den Kugeln 11 und den Metallschichten 18, 19 hergestellt, was durch Druck unter gleichzeitiger Wärmezufuhr erfolgt. Anschließend wird zur Bildung der Leiterbahnen 2 bis 6 jede Einzelplatte 38 geätzt.

Sollen Leiterbahnen 2 bis 6 einer Einzelplatte 38 mit den Leiterbahnen 2 bis 6 einer weiteren Einzelplatte 38 verbunden werden, dann werden an den vorgesehenen Verbindungsstellen mit Kugeln 11 versehene Ausnehmungen 8. 9 bei beiden Einzelplatten 38 an den gleichen Stellen vorgesehen. Außerdem wird die Isolierplatte 39 zwischen die beiden Einzelplatten 38 gelegt. die an den vorgenannten Verbindungsstellen Ausnehmungen 40 mit Kugeln 41 aufweist. Diese Kugeln 41 sind geringfügig dicker als die Dicke der Isolierplatte 39. Sodann wird die Mehrschichtplatte zwischen Unter- und Auflage 27. 28 verpreßt, wobei die Kugeln 41 durch die darüber und darunter liegenden Kugeln 11 mit den dazwischenliegenden Leiterbahnen 2, 5 bzw. 6, 3 diffusionsverschweißen. Hierbei werden gleichzeitig die Einzelplatten 38 auf die Isolierplatte 39 aufkaschiert.

Wenn im Vorstehenden von Kaschieren die Rede war, dann ist darunter zu verstehen, daß eine Fläche der miteinander zu verbindenden Teile eine Klebeschicht aufweist. beispielsweise aus einem Heißkleber, der bei Wärmezufuhr eine Klebeverbindung herstellt. Diese Klebeschicht muß natürlich immer dort Aussparungen aufweisen, wo Schweißverbindungen zwischen den Metallkörpern 11, 25, 41 und den Metallschichten bzw. Leiterbahnen hergestellt werden sollen. Diese Klebeschichten wurden auf den Zeichnungen der Übersichtlichkeit halber nicht dargestellt.

## Ansprüche

1. Verfahren zum Herstellen einer Schaltungsplatte, bestehend aus einer Isolierschicht (1) mit beidseits darauf aufkaschierten Metallschichten (2. 5. 18, 19), die über einen in eine Ausnehmung (8, 9, 10, 26) der Isolierschicht (1) eingesetzten Metallkörper (11. 25) elektrisch leitend miteinander verbunden sind, dadurch **gekennzeichnet**, daß ein Metallkörper (11, 25) verwendet wird, der geringfügig dicker ist als die Isolierschicht (1), dieser Metallkörper (11, 25) so in die Ausnehmung (8, 9, 10, 26) eingesetzt wird, daß er beidseits über die Oberflächen der Isolierschicht (1) übersteht und an den überstehenden Bereichen des Metallkörpers (11, 25) dieser mit den dort deformierten Metallschichten (2, 5, 18, 19) verbunden wird.

2. Verfahren nach Anspruch 1, dadurch **gekennzeichnet**, daß die eine Metallschicht (2) auf die die Ausnehmung (8) aufweisende Isolierschicht (1) aufkaschiert und sodann der Metallkörper (11) in die Ausnehmung (8) eingesetzt wird, wobei sein überstehender Bereich diese eine Metallschicht (2) deformiert und anschließend die andere Metallschicht (5) auf die Isolierschicht (1) aufgelegt wird.

3. Verfahren nach Anspruch 1, dadurch **gekennzeichnet**, daß nach dem Einsetzen des Metallkörpers (11, 25) in die Ausnehmung (8, 26) die beiden Metallschichten (2, 5) auf die Isolierschicht (1) aufgelegt werden.

4. Verfahren nach Anspruch 2 oder 3, dadurch **gekennzeichnet**, daß die aufgelegte Metallschicht (5) bzw. Metallschichten (2, 5) auf die Isolierschicht (1) aufkaschiert wird bzw. werden, wobei eine Deformation im überstehenden Bereich des Metallkörpers (11, 25) bewirkt wird und anschließend der Metallkörper (11, 25) mit den beiden Metallschichten (2, 5) verschweißt wird.

5. Verfahren nach Anspruch 2 oder 3, dadurch **gekennzeichnet**, daß die aufgelegte Metallschicht (5) bzw. Metallschichten (2, 5, 18, 19) mit dem Metallkörper (11, 25) verschweißt wird bzw. werden und sodann diese Metallschicht (5) bzw. Metallschichten (2, 5, 18, 19) auf die Isolierschicht (1) aufkaschiert wird bzw. werden.

6. Verfahren nach Anspruch 4 oder 5, dadurch **ge kennzeichnet**, daß zum Verschweißen der Metallschichten (2, 5, 18, 19) mit dem Metallkörper (11, 25) die Schaltungsplatte zwischen zwei parallel zueinander verlaufenden metallischen Druckflächen (27, 28) gelegt wird, die sodann an den überstehenden Bereichen des Metallkörpers (11, 25) gegen die Metallschichten (2, 5, 18, 19) pressen.

7. Verfahren nach Anspruch 4 oder 5, dadurch **gekennzeichnet**, daß zum Aufkaschieren die Schaltungsplatte zwischen zwei parallel zueinander verlaufenden elastischen Druckflächen (29, 30) gelegt wird, die sodann gegen die gesamten Metallschichten (2, 5, 18, 19) pressen.

8. Verfahren nach einem der Ansprüche 1 bis 7, dadurch **gekennzeichnet**, daß nach dem Aufkaschieren und Verschweißen auf mindestens eine Metallschicht (18, 19) eine weitere Isolierschicht (31) aufgebracht wird, die den deformierten Bereich dieser Metallschicht (18, 19) ausspart und auf diese weitere Isolierschicht (31) eine weitere Metallschicht (32, 33) aufgebracht wird, welche mit dem deformierten Bereich der einen Metallschicht (18, 19) verbunden wird.

9. Verfahren nach einem der Ansprüche 1 bis 8, dadurch **gekennzeichnet**, daß der Metallkörper eine Kugel (11) ist, die in die Ausnehmung (8) eingelegt wird.

10. Verfahren nach einem der Ansprüche 1 bis 9, dadurch **gekennzeichnet**, daß zum Herstellen einer mehrschichtigen Schaltungsplatte jeweils aus einer Isolierschicht (15, 16, 17) und einer Metallschicht (18, 19, 20) bestehende Einzelplatten (12, 13, 14) verwendet werden, die aufeinanderfolgend aufeinandergelegt werden und jeweils die Metallschicht (19, 20) der aufliegenden Einzelplatte (13, 14) mit der Folienschicht (18, 19) der darunterliegenden Einzelplatte (12, 13) über Metallkörper (11) verbunden wird, wozu die aufliegende Platte (13, 14) Ausnehmungen (23, 24) an den Stellen aufweist, an denen die darunterliegende Platte (12, 13) mit Metallkörpern (11) versehene Ausnehmungen (21, 22) aufweist.

11. Verfahren nach einem der Ansprüche 1 bis 10, dadurch **gekennzeichnet**, daß das Verschweißen ein Diffusionsverschweißen ist und das Diffusionsverschweißen und das Aufkaschieren in einem Arbeitsgang durchgeführt werden.

12. Verfahren nach einem der Ansprüche 1 bis 11, dadurch **gekennzeichnet**, daß zum Herstellen einer mehrschichtigen Schaltungsplatte Einzelplatten (38) und dazwischenliegende Isolierplatten (39) verwendet werden, wobei an den Verbindungsstellen zwischen den Leiterbahnen (2 bis 6) der einen Einzelplatte (38) und den Leiterbahnen (2 bis 6) der weiteren Einzelplatte (38) die Einzelplatten (38) und die dazwischenliegenden Isolierplatten (39) mit Metallkörpern (11, 41) versehene Ausnehmungen (8, 9, 40) vorgesehen sind, wobei die in der Isolierplatte (39) eingelegten Metallkörper (41) durch Druck auf die in den Einzelplatten (38) eingelegten Metallkörper (11) mit den dazwischenliegenden Leiterbahnen (2, 5; 3, 6) verschweißt werden und gleichzeitig die Einzelplatten (38) auf die Isolierplatte (39) aufkaschiert werden.

Fig. 1

Fig. 5

Fig 6

Fig. 2

Fig. 3

Fig. 4

Fig 7

Fig 8